# EUROPÄISCHE PATENTANMELDUNG

(11) **EP 3 945 331 A1**
(43) Veröffentlichungstag der Anmeldung: **02.02.2022**
(21) Anmeldenummer: 20188029.1
(22) Anmeldetag: 28.07.2020
(51) Int. Cl.: G01R 31/34

(54) **KLEMMBRETT FÜR EINE MASCHINE**

(71) Anmelder: Siemens Aktiengesellschaft, 80333 München (DE)
(72) Erfinder: Grillenberger, Michael, 90427 Nürnberg (DE); Gröger, Andreas, 81735 München (DE); Hoffmann, Andreas, 91077 Neunkirchen am Brand (DE)

(57) **Zusammenfassung**

Es wird ein Klemmbrett für eine elektrische Maschine angegeben, in das Sensoren zur Messung von Strom und/oder Spannung für die angeschlossenen Leitungen sowie eine Platine mit einer Auswerteschaltung eingegossen sind. Die Auswerteschaltung umfasst eine Schnittstelle, beispielsweise eine drahtlose Schnittstelle, zur Ausgabe der Messwerte der Sensoren.

## Beschreibung

Die Erfindung betrifft ein Klemmbrett zur Anbringung an eine Maschine, umfassend einen Klemmbrett-Körper mit einer oder mehreren Aussparungen für Bolzen für den elektrischen Anschluss von Wicklungen der elektrischen Maschine. Die Maschine kann dabei eine elektrische Maschine, also ein Elektromotor oder ein Generator sein, aber auch jede andere Form von Einrichtung, deren Anschluss über ein Klemmbrett vorgenommen wird, beispielsweise industrielle Prozesseinrichtungen.

Die Energiemessung, Strommessung oder Spannungsmessung an elektrischen Maschinen geschieht üblicherweise über Messgeräte, die soweit nötig an die zu der Maschine führenden Phasenleitungen angeschlossen werden. Sind die Phasenleitungen nicht oder schlecht zugänglich, ist die Messung elektrischer Größen dementsprechend erschwert. Auch erfordert die Messung der Größen immer ein menschliches Eingreifen zur geeigneten Anbringung des Messgeräts.

Es ist Aufgabe der vorliegenden Erfindung, eine Vorrichtung anzugeben, mit der die eingangs genannten Nachteile vermindert werden. Insbesondere soll es ermöglicht werden, in vereinfachter Weise elektrische Größen einer elektrischen Maschine zu ermitteln.

Diese Aufgabe wird hinsichtlich der Vorrichtung durch ein Klemmbrett mit den Merkmalen von Anspruch 1 gelöst.

Das erfindungsgemäße Klemmbrett für elektrische Maschinen umfasst einen Klemmbrett-Körper mit einer oder mehreren Aussparungen für Bolzen für den elektrischen Anschluss, eine oder mehrere Messeinrichtungen für elektrische Größen in an das Klemmbrett angeschlossenen elektrischen Leitungen, eine im oder am Klemmbrett-Körper angeordnete elektronischen Schaltung, die eine Kommunikationsschnittstelle umfasst, wobei die elektronische Schaltung ausgestaltet ist, Signale von den Messeinrichtungen aufzunehmen, aus den Signalen Messwerte zu ermitteln und die Messwerte über die Kommunikationseinrichtung zu versenden.

Für die Erfindung wurde erkannt, dass elektrische Maschinen wie Elektromotoren in der Regel ein Klemmbrett mit Motorklemmen haben. Diese werden in der Regel genutzt, um das Gerät mit der elektrischen Versorgung, also einem Versorgungsnetz, einem Schaltschrank oder einem Frequenz-Umrichter zu verbinden und mit elektrischer Energie zu versorgen. Im Normalfall hat dieser Klemmblock keine weitere Aufgabe. Daher wird bei bekannten elektrischen Maschinen für die Messung von elektrischen Größen wie Strom oder Spannung externe Messgeräte verwendet.

Das erfindungsgemäße Klemmbrett umfasst jedoch Messeinrichtungen, die eine Bestimmung elektrischer Größen für die angeschlossenen elektrischen Leitungen erlauben. Die so bestimmten elektrischen Größen können über die Kommunikationsschnittstelle versandt werden. Es wird so eine Möglichkeit geschaffen, die elektrischen Größen für die elektrische Maschine zu bestimmen, ohne eine externes Messgerät bereitstellen und mit den elektrischen Leitungen in Verbindung bringe zu müssen.

Vorteilhafte Ausgestaltungen des erfindungsgemäßen Klemmbretts gehen aus den abhängigen Ansprüchen hervor. Dabei können die Ausführungsformen der unabhängigen Ansprüche mit den Merkmalen eines der Unteransprüche oder vorzugsweise auch mit denen aus mehreren Unteransprüchen kombiniert werden. Demgemäß können noch zusätzlich folgende Merkmale vorgesehen sein:
Die elektronische Schaltung kann auf einem im Klemmbrettkörper angeordneten Träger angeordnet sein. Die elektronische Schaltung ist dann also zusammen mit dem Träger, typischerweise einer Platine, also Leiterplatte (englisch printed circuit board, PCB) weitgehend oder ganz innerhalb des Klemmbrettkörpers eingebettet. Beispielsweise kann der Träger vergossen sein. Der Klemmbrettkörper kann auch aus mehreren Teilen zusammengesetzt sein, in die der Träger vor der Zusammensetzung eingelegt wird. Daraus ergibt sich ein vibrationsunempfindlicher, stabiler Aufbau, bei dem die elektronische Schaltung vor rauer Umgebung geschützt ist. Auch ist die elektronische Schaltung damit von außen nicht zugänglich und je nach Ausgestaltung der Kommunikationsschnittstelle von außen möglicherweise nicht sichtbar.

In einer alternativen Ausgestaltung kann der Klemmbrettkörper der Träger der elektronischen Schaltung sein. In diesem Fall kann der gesamte Klemmbrettkörper in der Platine, also der Leiterplatte bestehen. Dabei ist es möglich, dass der Klemmbrettkörper als mehrlagige Platine ausgestaltet ist. Die elektronische Schaltung kann teilweise oder ganz auf dem Klemmbrettkörper oder im Klemmbrettkörper angeordnet sein. Wenigstens ein Teil der Messeinrichtungen kann als Spulenanordnung ausgestaltet sein, die die Aussparungen für die Bolzen umlaufen. Dadurch wird die Messung einer anliegenden Spannung ermöglicht. Die Spulenanordnung kann dabei bei einer mehrlagigen Platine als Verbund aus Leiterschleifen auf den einzelnen Platinen-Lagen realisiert sein. Auch ist es vorteilhaft möglich, aus einer solchen Spulenanordnung eine elektrische Versorgung der elektronischen Schaltung vorzunehmen.

Auch die Messeinrichtungen können in den Klemmbrett-Körper eingebettet sein. Dadurch sind auch die Messeinrichtungen von äußerem Zugriff und äußerem Einfluss geschützt wie auch die elektronische Schaltung. Die Messeinrichtungen sind dadurch auch mechanisch unabhängig von den in die Aussparungen einzusetzen Bolzen, die zusammen mit entsprechenden Muttern die elektrischen Leitungen halten.

Wenigstens ein Teil der Messeinrichtungen kann zur Aufnahme einer Spannung in zugeordneten an den an das Klemmbrett angeschlossenen elektrischen Leitungen ausgestaltet sein. Es handelt sich in diesem Fall also um Messeinrichtungen für eine Spannung, also um Spannungsmessgeräte. Insbesondere können alle Messeinrichtungen so ausgestaltet sein. Dabei ist es möglich, dass die Messeinrichtungen die Spannung zwischen Paaren der angeschlossenen elektrischen Leiter ermitteln, also jeweils zwei der Aussparungen und Bolzen zugeordnet sind.

Weiterhin kann wenigstens ein Teil der Messeinrichtungen zur Aufnahme eines Stroms in zugeordneten an das Klemmbrett angeschlossenen elektrischen Leitungen ausgestaltet sein. Es handelt sich in diesem Fall also um Messeinrichtungen für einen Strom, also um Strommessgeräte. Insbesondere können alle Messeinrichtungen so ausgestaltet sein. Dazu ist es zweckmäßig, wenn der Anschluss von elektrischen Leitungen der elektrischen Maschine selbst, also beispielsweise der Motorwicklungen auf einer ersten Seite des Klemmbretts passiert und der Anschluss von externen Leitungen, also beispielsweise der Phasenleitungen der elektrischen Versorgung auf einer zweiten Seite des Klemmbretts passiert. Dann kann vorteilhaft der Strom durch die Leitung und somit durch den Bolzen an einer Stelle im Klemmbrettkörper ermittelt werden.

Wengistens ein Teil der Messeinrichtungen kann beispielsweise als Hall-Sensor ausgestaltet sein. Hall-Sensoren arbeiten berührungslos und ermitteln den im Leiter fließenden Strom direkt, nicht nur seine zeitliche Ableitung. Der elektrische Leiter muss dabei auch nicht umschlossen werden. Noch flexibler ist die Anordnung des Hall-Sensors, wenn für die zu vermessenden elektrischen Leiter jeweils ein Ring aus beispielsweise Graphit den jeweiligen Leiter oder die Aussparung für den Bolzen umschließend im Klemmbrettkörper angeordnet ist. Der Hall-Sensor kann in diesem Fall in einer Aussparung des Graphit-Rings angeordnet werden.

Die elektronische Schaltung kann eine Steuerungseinrichtung umfassen, die ausgestaltet ist, von den Messeinrichtungen erzeugte Signale aufzunehmen und weiterzuverarbeiten. Zweckmäßig umfasst die Steuerungseinrichtung einen Mikrocontroller (MCU, microcontroller unit). Die Steuerungseinrichtung kann ausgestaltet sein, aus von den Messeinrichtungen aufgenommenen Signalen den jeweiligen Strom und/oder die jeweilige Spannung für einen oder mehrere der an das Klemmbrett angeschlossenen elektrischen Leitungen zu bestimmen. Mit anderen Worten werden die rohen und analogen elektrischen Signale durch die Steuerungseinrichtung in digitale und kalibrierte Wert umgesetzt.

Die Steuerungseinrichtung kann zusätzlich ausgestaltet sein, aus von den Messeinrichtungen aufgenommenen Signalen oder den digitalen Werten abgeleitete Größen wie Leistung, Blindleistung, Scheinleistung, Wirkleistung oder einen Phasenverschiebungswinkel zu ermitteln. Damit ist es nicht nötig, solche Größen außerhalb der elektrischen Maschine zu berechnen, sondern diese Werte können direkt ausgelesen werden. Die Steuerungseinrichtung kann dazu beispielsweise ausgestaltet sein, eine FFT (Fast Fourier Transformation) durchzuführen.

Die elektronische Schaltung kann ferner eine Speichereinrichtung zur Speicherung von ermittelten Größen umfassen. Die Steuerungseinrichtung ist dann zweckmäßig ausgestaltet, ermittelte Größen und Werte dort abzulegen, insbesondere mit einem Zeitstempel. Später können die Werte aus der Speichereinheit ausgelesen, verarbeitet und über die Kommunikationsschnittstelle versandt werden.

Die Kommunikationsstelle kann einen Kabelanschluss umfassen. Beispielsweise kann die Kommunikationsschnittstelle als kabelbasierter LAN-Anschluss oder als USB-Schnittstelle ausgestaltet sein und dazu eine LAN-Buchse oder USB-Buchse umfassen. Vorteilhaft ist dadurch eine sichere Kommunikationsmöglichkeit geschaffen. Weiterhin ist es möglich, eine Stromversorgung der elektronischen Schaltung über die Kabelverbindung bereitzustellen.

Alternativ oder zusätzlich kann die Kommunikationsschnittstelle eine Vorrichtung für den drahtlosen Datenaustausch umfassen. Eine solche Kommunikationsschnittstelle ist beispielsweise eine WLAN-Schnittstelle, Bluetooth-Schnittstelle oder ZigBee-Schnittstelle. Vorteilhaft ist dadurch keine Kabelverbindung notwendig, was das Auslesen der Messdaten vereinfacht und bei vielen modernen mobilen Endgeräten sogar erst die Verbindung ermöglicht. Das Klemmbrett kann vorteilhaft dadurch so gestaltet werden, dass die Unterschiede zu einem aus dem Stand der Technik bekannten Klemmbrett von außen unsichtbar sind.

Die Steuerungseinrichtung ist bevorzugt ausgestaltet, die Kommunikationsschnittstelle so zu steuern, dass eine Verbindung zu externen Geräten, beispielsweise zu Mobiltelefonen oder Tablet-PCs hergestellt wird. Die ermittelten Werte werden dann bevorzugt an verbundene Geräte übermittelt.

Die elektronische Schaltung kann eine Einrichtung zur Aufnahme von Umgebungsenergie aufweisen, mit der eine Stromversorgung der elektronischen Schaltung vorgenommen wird. Die Einrichtung kann Energie beispielsweise aus den vorhandenen elektrischen Feldern, aus Temperaturgradienten oder aus Vibrationen entnehmen und daraus eine Versorgungsspannung ableiten.

Das Klemmbrett kann für jede Aussparung eine Messeinrichtung umfassen oder nur für einen Teil der Aussparungen, also elektrischen Leitungen. Bei einem Klemmbrett mit sechs Aussparungen für sechs Bolzen sind vorteilhaft Messeinrichtungen für genau drei der Aussparungen vorhanden, um eine Messung an den drei angeschlossenen Phasenleitungen zu ermöglichen.

Das Klemmbrett umfasst bevorzugt einen Bolzen mit einem Gewinde zum Aufschrauben von Muttern zur Befestigung von elektrischen Leitungen in wenigstens einem Teil der Aussparungen.

Im Folgenden wird die Erfindung anhand der Figuren der Zeichnung im Zusammenhang mit einem Ausführungsbeispiel näher beschrieben und erläutert. Dabei werden für übereinstimmende Merkmale dieselben Bezugszeichen verwendet. Dabei zeigen
- Figur 1: ein elektrisches Schaltbild eines mit einem Frequenzumrichter verbundenen Elektromotors,
- Figur 2: eine dreidimensionale Darstellung eines Klemmbretts des Elektromotors,
- Figur 3: eine Seitenansicht des Klemmbretts,
- Figuren 4 und 5: Beispiele für im Klemmbrett angeordnete Platinen,
- Figur 6: eine mehrlagige Platine als Klemmbrett.

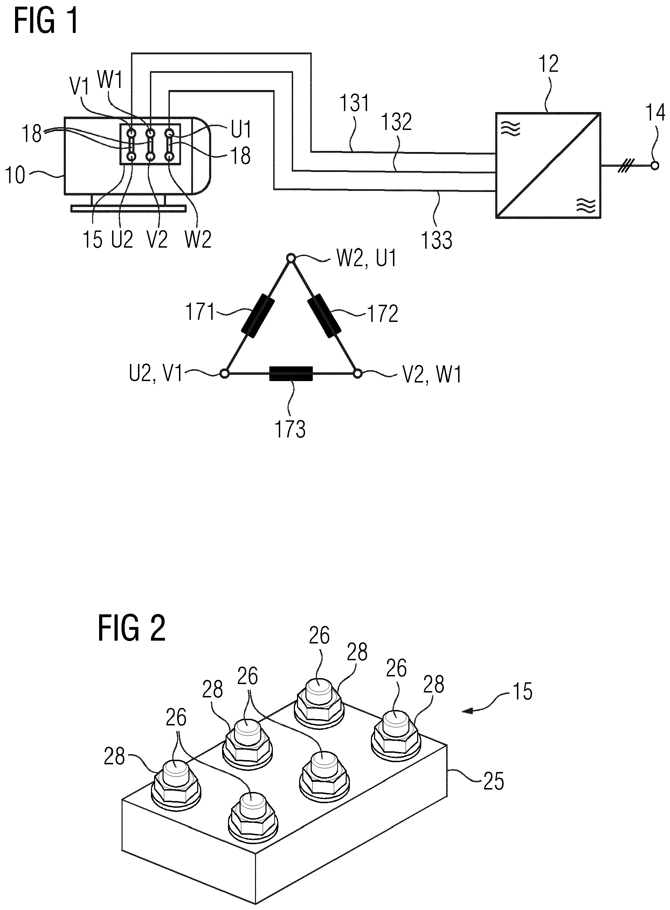

Das elektrische Schaltbild der Figur 1 zeigt den Zusammenschluss eines Asynchronmotors 10 mit einem Frequenzumrichter 12. Der Frequenzumrichter 12 stellt ein Dreiphasensystem mit variabler Frequenz zur Verfügung und ermöglicht so ein sanftes Anlaufen des Asynchronmotors 10 und einen Betrieb mit einstellbarer Drehzahl. Der Frequenzumrichter 12 ist eingangsseitig mit einem Versorgungsnetzwerk 14 verbunden und über drei Phasenleitungen 131...133 mit dem Asynchronmotor 10.

Der Anschluss des Asynchronmotors 10 ist anhand seines schematisch dargestellten Klemmbretts 15 gezeigt, das ein Ausführungsbeispiel für die Erfindung ist. Das Klemmbrett 15 weist Anschlüsse U1, U2, V1, V2, W1 und W2 für die jeweiligen Enden der Motorwicklungen 171...173 auf. Der Asynchronmotor 10 ist in diesem Fall in Dreiecksschaltung angeschlossen. Am Klemmbrett 15 sind dazu passend Verbinder 18 zwischen den Anschlusspaaren W2 und U1, U2 und V1 und V2 und W1 vorhanden.

Figur 2 zeigt eine perspektivische Darstellung des Klemmbretts 15. Das Klemmbrett 15 umfasst einen im Wesentlichen quaderförmigen Klemmbrettkörper 25. Der Klemmbrettkörper 25 weist in diesem Ausführungsbeispiel für die Erfindung sechs Aussparungen auf, in die jeweils ein Bolzen 26 eingelassen ist. In anderen Ausführungen des Klemmbretts 15 kann dieses auch eine andere Zahl von Aussparungen und Bolzen aufweisen wie beispielsweise drei, acht oder neun Bolzen.

Die Bolzen 26 weisen ein Gewinde auf, auf das eine oder mehrere Muttern 28 aufgeschraubt sind. Die Bolzen 26 zusammen mit den Muttern 28 dienen der Befestigung der von außerhalb des Asynchronmotors 10 herangeführten Phasenleitungen 131...133 einerseits und der Befestigung der Anschlüsse der Motorwicklungen 171...173 andererseits. Damit wird auch die gewünschte elektrische Verbindung zwischen den Phasenleitungen 131...133 und den Motorwicklungen 171...173 hergestellt.

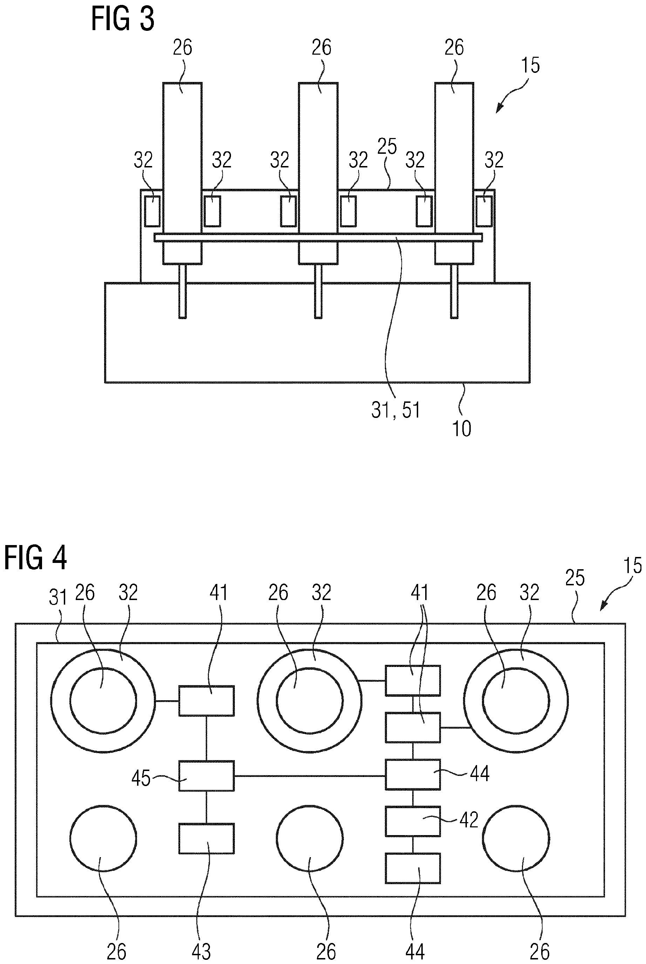

Das Klemmbrett 15 unterscheidet sich von bekannten Klemmbrettern durch Vorrichtungen, die in der perspektivischen Darstellung der Figur 2 nicht sichtbar sind. Daher entspricht die Darstellung des Klemmbretts 15 in Figur 2 bekannten Klemmbrettern. Die Figuren 3 und 4 zeigen weitere Ansichten des Klemmbretts 15, in denen die Unterschiede zu bekannten Klemmbrettern gezeigt sind. In anderen Ausführungsmöglichkeiten für die Erfindung kann der Unterschied zu bekannten Klemmbrettern auch von außen erkennbar sein, wie weiter unten erläutert.

In der in Figur 3 gezeigten Seitenansicht des Klemmbretts 15 ist erkennbar, dass dieses eine Platine 31 umfasst. Die Platine 31 ist in diesem Ausführungsbeispiel den Klemmbrettkörper 25 eingegossen. In anderen Ausführungsvarianten kann die Platine auch auf andere Weise in den Klemmbrettkörper 25 eingelassen sein, beispielsweise durch Einlegen in einen geteilt ausgeführten Klemmbrettkörper 25.

Zusätzlich zu der Platine 31 umfasst das Klemmbrett 15 weiterhin Hall-Sensoren 32. In diesem Ausführungsbeispiel ist für jeden zweiten der Bolzen 26 und damit jeder der anzuschließenden Phasenleitungen 131...133 ein eigener Hall-Sensor 32 zugeordnet, also insgesamt drei Hall-Sensoren. In anderen Ausführungsbeispielen kann aber auch eine andere Anzahl von Hall-Sensoren 32 verwendet werden, beispielsweise sechs Hall-Sensoren 32 oder nur ein Hall-Sensor 32. Auch werden in anderen Ausführungsformen andere Typen von Sensoren verwendet. Es ist auch möglich, mehrere verschiedene Typen von Sensoren in einem Klemmbrett 15 zu verwenden.

Die in diesem Beispiel verwendeten Hall-Sensoren 32 sind mit einer Signalaufnahme auf der Platine 31 verbunden. Der stark schematisierte Aufbau der Elektronik auf der Platine 31 ist in Figur 4 dargestellt.

Die Signalaufnahme umfasst in diesem Ausführungsbeispiel für jeden der Hall-Sensoren 32 einen Analog-Digital-Wandler 41, der das analoge Signal des jeweiligen Hall-Sensors 32 in einen digitalen Spannungswert umsetzt. Die digitalen Spannungswerte werden über Verbindungsleitungen auf der Platine einem Mikrocontroller 42 zugeführt. Der Mikrocontroller 42 kann eine weitere Verarbeitung der Signale durchführen.

Die weitere Verarbeitung kann dabei einen oder mehrere der folgenden Schritte umfassen:
Der Mikrocontroller 42 kann ausgestaltet sein, also eine Programmierung aufweisen, die Signale zu speichern. Dafür ist zweckmäßig auf der Platine 31 eine Speichereinheit 43 vorhanden, die die zu speichernden Signale aufnimmt. Die Speichereinheit 43 ist dabei zweckmäßig als permanenter Speicher ausgestaltet, also als ein Speicher, der zur Aufrechterhaltung der gespeicherten Daten keine Stromversorgung benötigt. Permanente Speicher sind beispielsweise Flash-Speicher, die in USB-Sticks verwendet werden. Für eine kurzfristige Speicherung kann die Speichereinheit 43 aber auch als flüchtiger Speicher ausgestaltet sein.

Der Mikrocontroller 42 kann ausgestaltet sein, gespeicherte Signale wieder zu laden, also auszulesen und einer Auswertung zu unterziehen. Beispielsweise kann so eine Mittelung von Messwerten durchgeführt werden und so ein geglättetes Signal erzielt werden, was mit den zu einem einzigen Zeitpunkt vorliegenden Signalen der Hall-Sensoren 32 nicht möglich wäre. Auch können aus den gespeicherten Daten beispielsweise Werte ermittelt werden, die grundsätzlich eine Mehrzahl von Daten erfordern, beispielsweise Auswertungen bezüglich der Frequenz und Phasenlage des in einer der Phasenleitungen 131...133 fließenden Wechselstroms.

Der Mikrocontroller 42 kann weiterhin ausgestaltet sein, aus den zu einem Zeitpunkt vorliegenden Signalen und wenn nötig aus in der Speichereinheit 43 gespeicherten Daten abgeleitete Größen zu ermitteln. So können aus Daten zu Strom und Spannung unter anderem die Leistung, Blindleistung, Scheinleistung, Wirkleistung oder ein Phasenverschiebungswinkel ermittelt werden. Auch die abgeleiteten Größen können in der Speichereinheit 43 abgelegt werden.

Der Mikrocontroller 42 kann weiterhin ausgestaltet sein, die aus den Signalen ermittelten Werte von Spannung und/oder Strom zu versenden. Für die Versendung ist auf der Platine 31 eine Bluetooth-Schnittstelle 44 vorhanden. Die Bluetooth-Schnittstelle 44 kann eine drahtlose Verbindung zu einem externen Empfänger für die versendeten Informationen herstellen. Dadurch ist der Mikrocontroller 42 in die Lage versetzt, die aktuell ermittelten Werte, aber auch abgeleitete Größen und/oder in der Speichereinheit 43 gespeicherte Daten an den Empfänger zu übermitteln.

Die Übermittlung kann dabei sofort stattfinden, d.h. direkt zum Zeitpunkt der Aufnahme von Messwerten werden diese auch an den oder die Empfänger übermittelt. Die Übermittlung kann aber auch später stattfinden, indem die ermittelten Werte und Größen in der Speichereinheit zwischengespeichert werden. Neben den direkten Messwerten der Hall-Sensoren 32 können auch abgeleitete Größen an den oder die Empfänger übertragen werden.

Die Stromversorgung für die Platine 31 und die darauf angeordneten Elemente, also unter anderem den Mikrocontroller 42, die Bluetooth-Schnittstelle 44, ist in diesem Ausführungsbeispiel durch eine Einrichtung 45 zur Aufnahme von Umgebungsenergie - englisch als Energy Harvesting bekannt - gegeben. Die Einrichtung 45 ist ebenfalls auf der Platine 31 angeordnet. Sie kann ausgestaltet sein, aus verschiedenen vorliegenden Energieformen die für den Betrieb der Platine 31 nötigen Strom zu erzeugen, beispielsweise aus Temperaturgradienten, den sich im Betrieb des Asynchronmotors 10 ergebenden elektrischen Feldern oder Vibrationen.

Da in diesem Ausführungsbeispiel keine die Platine 31 und die Hall-Sensoren 32 vollständig innerhalb des Klemmbrettkörpers 25 angeordnet sind, sind sie von außen nicht erkennbar und damit das Klemmbrett 15 von außen sehr ähnlich zu anderen, bekannten Klemmbrettern. Es ist insbesondere also ohne Weiteres in derselben Weise zu montieren und anzuschließen wie ein bekanntes Klemmbrett, bietet aber im Gegensatz zu bekannten Klemmbrettern die Möglichkeit, elektrische Größen der angeschlossenen Phasenleitungen 131...133 zu messen und die Messergebnisse an in der Umgebung vorhandene Empfänger zu übermitteln.

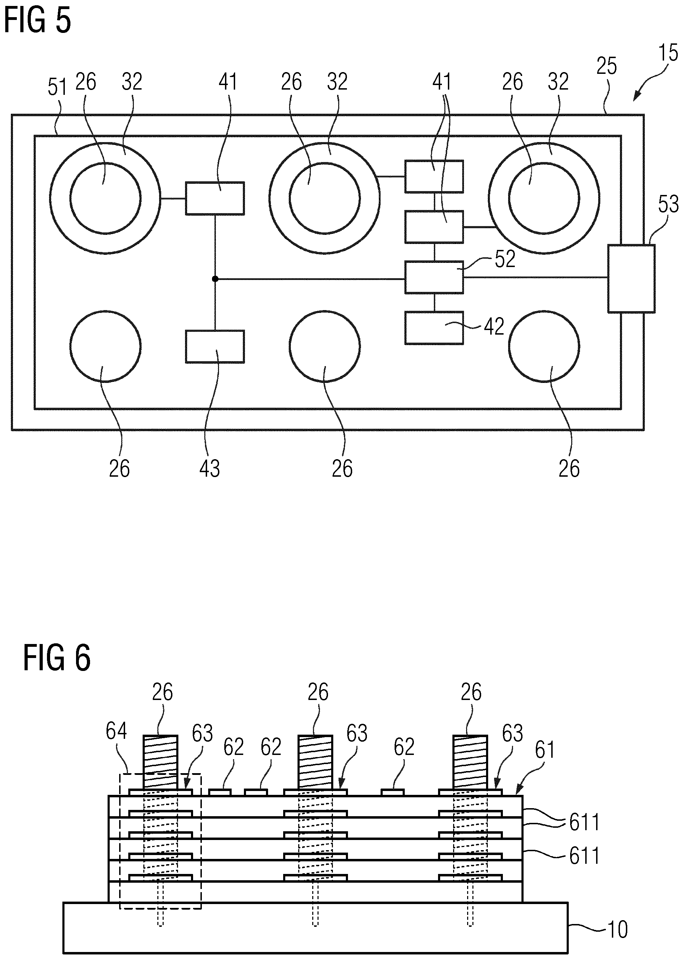

Ein weiteres Ausführungsbeispiel für die Erfindung ist in Figur 5 dargestellt. Die in Figur 5 gezeigte Platine 51 umfasst ebenfalls die Analog-Digital-Wandler 41 und den Mikrocontroller 42.

An der Stelle der Bluetooth-Schnittstelle 44 ist auf der Platine 51 jedoch eine USB-Schnittstelle 52 vorhanden. Die USB-Schnittstelle 52 ist eine kabelgebundene Schnittstelle und die Platine 51 umfasst daher eine USB-Buchse 53, die von außen am Klemmbrett 15 erkennbar und erreichbar sein muss. Die USB-Schnittstelle 52 erlaubt den Anschluss eines oder mehrerer Empfänger für die vom Mikrocontroller 42 versendeten Messwerte und Größen.

Zusätzlich bietet die USB-Schnittstelle 52 die Möglichkeit, die Platine 51 mit Strom zu versorgen. Dadurch entfällt die Notwendigkeit einer Energieversorgung aus Umgebungsenergie und die Einrichtung 45 ist daher auf der Platine 51 nicht vorhanden.

Figur 6 zeigt eine Seitenansicht eines Klemmbretts 15, bei dem der Klemmbrettkörper als eine mehrlagige Platine 61 umgesetzt ist. Die Platine 61 umfasst in diesem Beispiel fünf Lagen 611. Bauelemente 62 der elektronischen Schaltung sind auf der Oberseite der Platine 61 angeordnet. Dabei sind die durch die anliegenden Spannungen nötigen Abstände der Elemente der elektronischen Schaltung von den Bolzen 26 einzuhalten.

Eine Messeinrichtung 63 zur Spannungsmessung ist dabei in der Platine 61 als Spule 64 aufgebaut. Die Spule 64 umfasst dabei eine Mehrzahl von Leiterschleifen 63 auf den Lagen 611, die mittels Durchkontaktierungen durch die einzelnen Lagen 611 untereinander verbunden sind und so die Spule 64 formen. Jede der Spulen 64 umläuft dabei einen der Bolzen 26. Mittels der Spulen 64 kann die elektrische Spannung am jeweiligen Bolzen, also an einer angeschlossenen Leitung aufgenommen und in ein elektrisches Signal gewandelt werden.

Weiterhin ist es auch möglich, aus den Spulen 64 eine Stromversorgung der elektronischen Schaltung vorzunehmen. Dadurch entfällt die Notwendigkeit einer Einrichtung 45 zur Aufnahme von Umgebungsenergie, es ist aber auch nicht notwendig, die elektronische Schaltung mit einer Kabelverbindung anzuschlie-βen. Es kann also auf diese Weise vorteilhaft eine drahtlose Anbindung und Weitergabe der Daten nach außen erfolgen.

Die Verwendung von Spulen 64 ist dabei nicht auf diese Ausführungsbeispiel mit einer mehrlagigen Platine begrenzt, wie auch Hall-Sensoren nicht nur bei einer im Klemmbrettkörper 25 vergossenen Platine 31, 51 verwendet werden können. Vielmehr können die Sensortypen bei allen beschriebenen Arten von Platine 31, 51, 61 und Klemmbrettkörper 25 verwendet werden. Auch die Art der Datenweitergabe - drahtlos oder kabelgebunden - und die Art der Stromversorgung sind unter den gegebenen Ausführungsbeispielen vertauschbar.

### Bezugszeichenliste

- 10: Asynchronmotor
- 12: Frequenzumrichter
- 131...133: Phasenleitungen
- 14: Versorgungsnetzwerk
- 15: Klemmbrett
- 171...173: Motorwicklungen
- 18: Verbinder
- 25: Klemmbrettkörper
- 26: Bolzen
- 28: Muttern
- 31, 51, 61: Platine
- 32: Hall-Sensor
- 41: Analog-Digital-Wandler
- 42: Mikrocontroller
- 43: Speichereinheit
- 44: Bluetooth-Schnittstelle
- 45: Einrichtung zur Aufnahme von Umgebungsenergie
- 52: USB-Schnittstelle
- 53: USB-Buchse
- 62: Bauelemente der elektronischen Schaltung

## Patentansprüche

1. Klemmbrett (15) für Maschinen (10), umfassend
- einen Klemmbrett-Körper (25) mit einer oder mehreren Aussparungen für Bolzen (26) für den elektrischen Anschluss,
- eine oder mehrere Messeinrichtungen (32) für elektrische Größen in an das Klemmbrett (15) angeschlossenen elektrischen Leitungen,
- eine im oder am Klemmbrett-Körper (25) angeordnete elektronische Schaltung, die eine Kommunikationsschnittstelle (44, 52) umfasst, wobei die elektronische Schaltung ausgestaltet ist, Signale von den Messeinrichtungen (32) aufzunehmen, aus den Signalen Messwerte zu ermitteln und die Messwerte über die Kommunikationseinrichtung (44, 52) zu versenden.

2. Klemmbrett (15) nach Anspruch 1, bei dem die elektronische Schaltung auf einem im Klemmbrettkörper (25) angeordneten Träger (31, 51) angeordnet ist.

3. Klemmbrett (15) nach Anspruch 1, bei dem der Klemmbrettkörper (25) der Träger der elektronischen Schaltung ist.

4. Klemmbrett (15) nach einem der vorangehenden Ansprüche, bei dem die Messeinrichtungen (32) in den Klemmbrett-Körper (25) eingebettet sind.

5. Klemmbrett (15) nach einem der vorangehenden Ansprüche, bei dem wenigstens ein Teil der Messeinrichtungen (32) zur Aufnahme einer Spannung in zugeordneten an den an das Klemmbrett (15) angeschlossenen elektrischen Leitungen ausgestaltet ist.

6. Klemmbrett (15) nach Anspruch 5, bei dem der Klemmbrettkörper (25) eine mehrlagige Platine (61) ist und wenigstens ein Teil der Messeinrichtungen (32) als Spulenanordnung (64) ausgestaltet sind, die als verbundene Leiterschleifen (63) auf der mehrlagigen Platine (61) ausgebildet sind.

7. Klemmbrett (15) nach einem der vorangehenden Ansprüche, bei dem wenigstens ein Teil der Messeinrichtungen (32) zur Aufnahme eines Stroms in zugeordneten an das Klemmbrett (15) angeschlossenen elektrischen Leitungen ausgestaltet ist.

8. Klemmbrett (15) nach Anspruch 7, bei dem wenigstens ein Teil der Messeinrichtungen (32) als Hall-Sensor (32) ausgestaltet ist.

9. Klemmbrett (15) nach einem der vorangehenden Ansprüche, bei dem die elektronische Schaltung eine Steuerungseinrichtung (42) umfasst, die ausgestaltet ist, von den Messeinrichtungen (32) erzeugte Signale aufzunehmen und weiterzuverarbeiten.

10. Klemmbrett (15) nach Anspruch 9, bei dem die Steuerungseinrichtung (42) ausgestaltet ist, aus von den Messeinrichtungen (32) aufgenommenen Signalen Strom und/oder Spannung für einen oder mehrere der an das Klemmbrett (15) angeschlossenen elektrischen Leitungen zu bestimmen.

11. Klemmbrett (15) nach Anspruch 9 oder 10, bei dem die Steuerungseinrichtung (42) ausgestaltet ist, aus von den Messeinrichtungen (32) aufgenommenen Signalen abgeleitete Größen wie Leistung, Blindleistung, Scheinleistung, Wirkleistung oder einen Phasenverschiebungswinkel zu ermitteln.

12. Klemmbrett (15) nach einem der vorangehenden Ansprüche, bei dem die Kommunikationsschnittstelle (44, 52) einen Kabelanschluss (53) umfasst.

13. Klemmbrett (15) nach einem der vorangehenden Ansprüche, bei dem die Kommunikationsschnittstelle (44, 52) eine Vorrichtung (44) für den drahtlosen Datenaustausch umfasst.

14. Klemmbrett (15) nach einem der vorangehenden Ansprüche mit einem Bolzen (26) in wenigstens einem Teil der Aussparungen.

15. Elektrische Maschine (10), insbesondere Elektromotor (10), umfassend ein Klemmbrett (15) nach einem der vorangehenden Ansprüche.
